# EUROPÄISCHE PATENTSCHRIFT

(11) **EP 1 488 428 B1**
(45) Veröffentlichungstag und Bekanntmachung des Hinweises auf die Patenterteilung: **06.09.2006**
(21) Anmeldenummer: 03712035.9
(22) Anmeldetag: 17.03.2003
(51) Int. Cl.: G11C 11/41

(54) **REGISTERZELLE UND VERFAHREN ZUM SCHREIBEN AUF DIE REGISTERZELLE**
REGISTER CELL AND METHOD FOR WRITING INTO SAID REGISTER CELL
CELLULE DE REGISTRE ET PROCEDE POUR EFFECTUER UNE INSCRIPTION DANS UNE CELLULE DE REGISTRE

(30) Priorität: 25.03.2002 DE 10213267
(43) Veröffentlichungstag der Anmeldung: 22.12.2004
(73) Patentinhaber: Infineon Technologies AG, 81669 München (DE)
(72) Erfinder: ELBE, Astrid, 81243 München (DE); FISCHER, Wieland, 80469 München (DE); JANSSEN, Norbert, 81667 München (DE); ROEMER, Tanja, München 80686 (DE); SEDLAK, Holger, 82054 Lochhofen/Sauerlach (DE); SEIFERT, Jean-Pierre, Hillsborough, OR 97124 (US)
(74) Vertreter: Schoppe, Fritz
(86) Internationale Anmeldenummer: PCT/EP2003/002755
(87) Internationale Veröffentlichungsnummer: WO 2003/081367

(56) Entgegenhaltungen:
- EP-A- 1 026 695
- US-A- 4 916 333
- US-A- 5 177 706
- US-A- 5 453 950
- US-A- 5 966 320

## Beschreibung

Die vorliegende Erfindung bezieht sich auf die Datenspeicherung und insbesondere auf das sichere Speichern von Daten in einem Register.

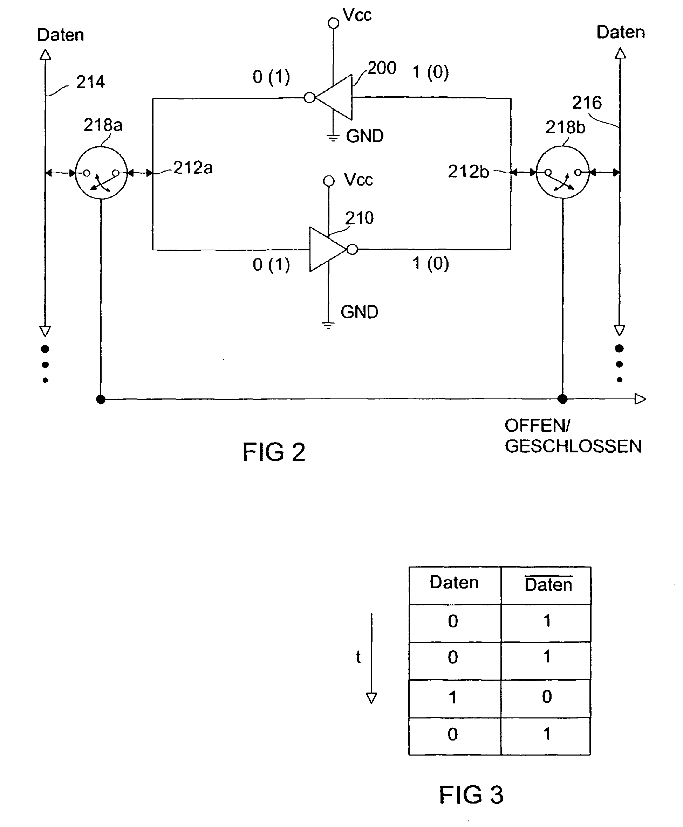

Fig. 2 zeigt eine Latch-Speicherzelle eines Registers. Ein 32-Bit-Latch beispielsweise umfaßt 32 Speicherzellen der Form, wie sie prinzipiell in Fig. 2 dargestellt ist. Eine Latch-Speicherzelle umfaßt einen ersten Inverter 200 und einen zweiten Inverter 210, die gegensinnig verschaltet sind, derart, daß der Ausgang beispielsweise des oberen Inverters 200 in den Eingang des unteren Inverters 210 eingespeist wird. Beide Inverter sind somit, wie es in Fig. 2 gezeigt ist, durch einen ersten Verknüpfungspunkt 212a, der den Ausgang eines Inverters mit dem Eingang des anderen Inverters verbindet, und durch einen zweiten Verknüpfungspunkt 212b gekoppelt, der den Eingang des einen Inverters 200 mit dem Ausgang des anderen Inverters 210 verknüpft. Beide gegensinnig verkoppelten Inverter 200, 210 sind zwischen eine Datenleitung 214 und eine Leitung 216 für negierte Daten geschaltet, wobei zwischen den Datenleitungen 214 und 216 und den jeweiligen Verknüpfungspunkten 212a, 212b Schalter 218a und 218b vorgesehen sind. Die beiden Schalter 218a und 218b sind durch eine Steuerleitung 220 steuerbar, um die Schalter 218a, 218b zu schließen, wenn die Speicherzelle ausgelesen werden soll oder beschrieben werden soll, und um die Schalter 218a, 218b zu öffnen, wenn mit der Latch-Speicherzelle nichts geschehen soll, d. h. wenn von ihr weder gelesen werden soll noch auf sie geschrieben werden soll.

Beide Inverter 200, 210 haben jeweils Versorgungsanschlüsse V_{cc} und Masseanschlüsse GND, um die Transistoren, aus denen die Inverter aufgebaut sind, zu versorgen. Prinzipiell ist die Inverterstruktur von Fig. 2 eine Rückkopplungsschaltung dahingehend, daß wenn beispielsweise auf der rechten Seite Bezug nehmend auf Fig. 2 eine "1" anliegt, auf der linken Seite eine "0" erzeugt wird, während, wenn der entgegengesetzte Fall betrachtet wird, d. h. der Fall, der in Fig. 2 mit Klammern bezeichnet ist, logisch entgegengesetzte Zustände gehalten werden. Ladungsverluste innerhalb der Inverter werden durch die Versorgungsspannung V_{cc} ausgeglichen, derart, daß, wenn eine Versorgungsspannung anliegt, entweder die "0" oder die "1" gehalten wird. Im "Halten"-Zustand sind die beiden Schalter 218a, 218b offen, derart, daß keine Verbindung zur Leitung Daten 214 oder zur Leitung Nicht-Daten 216 vorhanden ist.

Soll der Inverter beispielsweise unter Verwendung der Leitung "Daten" 214 ausgelesen werden, so ist eine Treiberschaltung (in Fig. 2 nicht gezeigt) für die Leitung 214 deaktiviert. Ferner wird der Schalter 218a geschlossen, derart, daß die beiden Inverter 200, 210 die Datenleitung 214 mit ihrem jeweiligen Zustand gewissermaßen treiben. Dasselbe kann alternativ oder gleichzeitig mit der Treiberschaltung für die Leitung 216 bzw. mit dem Schalter 218b für die "Negativ"-Seite des Latch-Speichers durchgeführt werden.

Sollen dagegen Daten in die in Fig. 2 gezeigte Registerzelle geschrieben werden, so sind zwei Fälle zu unterscheiden. Generell werden beim Schreiben in eine in Fig. 2 gezeigte Speicherzelle typischerweise beide Schalter 218a, 218b unter Verwendung der Steuerleitung 220 geschlossen. Darüber hinaus werden die Leitungstreiber für die Leitungen 214 und 216 aktiviert, um die Leitungen 214 bzw. 216 zu treiben, während, wie es ausgeführt worden ist, beim Lesen aus der Speicherzelle die Leitungen nicht getrieben werden, sondern die Speicherzellen selbst als Leitungstreiber wirken.

Im ersten Fall, in dem Daten in die Speicherzelle geschrieben werden, und die in die Speicherzelle zu schreibenden Daten die gleichen sind, wie sie in einer Speicherzelle gehalten werden, wird mit der Speicherzelle nichts passieren. Dieser Fall ist in den ersten Zeilen der Tabelle von Fig. 3 dargestellt.

Im zweiten Fall wird durch ein Schreiben auf die Speicherzelle der Dateninhalt verändert. Wenn beispielsweise auf der linken Seite der beiden Inverter 200, 210 von Fig. 2 eine "0" war, und eine "1" eingeschrieben werden soll, so muß der Zustand der Speicherzelle geändert werden. Hierzu wird die linke Seite der beiden Inverter über die Datenleitung 214 in einen logischen "1"-Zustand gezogen, während die rechte Seite der beiden Inverter 200, 210 durch die Daten-Nicht-Leitung 216 in den logischen "0"-Zustand gezogen wird, wie es auch aus einem Vergleich der zweiten und dritten Zeile von Fig. 3 ersichtlich wird.

Wird dann, in einem zeitlich nachfolgenden Zustand, wieder in die Speicherzelle geschrieben, und wird der Inhalt der Speicherzelle wieder verändert, so geschieht das gleiche, jedoch mit unterschiedlicher Polarität.

Wie es ausgeführt worden ist, ändert sich der Zustand der Speicherzelle nicht, wenn derselbe Wert, der vorher in der Speicherzelle war, in die Speicherzelle geschrieben wird. Wird jedoch der Wert der Speicherzelle geändert, so ändern sich die Zustände in der Speicherzelle. Typischerweise werden CMOS-Schaltungen verwendet. Bei CMOS-Schaltungen findet bei sich nicht veränderndem Zustand typischerweise kein Stromverbrauch statt, während ein merkbarer Stromverbrauch auftritt, wenn die CMOS-Schaltung eine Zustandsänderung durchführen muß.

Wenn die in Fig. 2 gezeigte Speicherzelle zum Speichern von sensitiven Daten vorgesehen ist, beispielsweise zum Speichern von geheimen Schlüsseln beim RSA-Algorithmus oder irgend einem anderen Kryptoalgorithmus, so könnte ein Angreifer, wenn er den Stromverbrauch der Leitungstreiberschaltung zum Treiben der Leitungen 214 und 216 von Fig. 2 überwacht, oder wenn er die V_{cc}-Anschlüsse der Inverter 200, 210 überwacht, bereits anhand des Leistungsprofils und von Arbeitstaktinformationen die geheime Information extrahieren, ob sich der Zustand der Speicherzelle geändert hatte oder nicht. Wenn davon ausgegangen wird, daß es für den Angreifer nicht möglich ist, eine einzelne Speicherzelle zu überwachen, so dürfte dies leichter möglich sein, wenn ein gemeinsamer Versorgungsanschluß für ein Register mit vielen Speicherzellen, wie z. B. 8, 16, 32 oder 64 Speicherzellen, oder aber auch, wenn an Langzahlrechenwerke für kryptographische Anwendungen gedacht wird, 2304 Speicherzellen vorgesehen ist.

Wie es bereits ausgeführt worden ist, benötigt eine Speicherzelle Strom bzw. Leistung, wenn sie ihren Zustand ändert, während sie keinen Strom benötigt, wenn ihr Zustand gleich bleibt. Wenn diese Betrachtung auf ein gesamtes Register mit mehreren Speicherzellen übertragen wird, ergibt sich Folgendes. Wird beispielsweise davon ausgegangen, daß ein Register mit 16 Speicherzellen zu Anfang auf "0" initialisiert war, und wird nunmehr in das Register eine Zahl geladen, die 16 Bit hat, wobei 10 Bit eine "1" sind, und wobei die restlichen 6 Bit eine "0" darstellen, so werden in 10 der 16 Speicherzellen dieses Registers solche Zustandsänderungen auftreten. Am Leistungsversorgungsanschluß wird daher ein Leistungs-Peak mit einer bestimmten Höhe erkennbar sein, die davon abhängt, wie viele Bits sich von "0" auf "1" verändert haben. Im vorliegenden Beispiel wird der Leistungs-Peak eine Höhe haben, die gleich dem 10-fachen eines Einheits-Leistungspeaks ist, der anfällt, wenn sich eine einzige Speicherzelle hinsichtlich ihres Zustands ändert. Die Anzahl der Bits in einer Zahl wird auch als Hamming-Gewicht (a) der Zahl a bezeichnet.

Allein aufgrund des Leistungsverbrauchs beim Schreiben auf ein Register kann ein Angreifer somit einen Hinweis auf die Differenz des Hamming-Gewichts des alten Registerinhalts und des Hamming-Gewichts des neuen Registerinhalts erhalten. Ein Angreifer muß somit, um das Register-Schreiben gewöhnlich "unerlaubt" zu überwachen, das Hamming-Gewicht der ersten Zahl haben, um dann immer die Differenz der Hamming-Gewichte aufeinanderfolgender Speicherwerte anhand einer Leistungsanalyse zu erkennen. Typischerweise sind Register zu Beginn auf einen Null-Zustand initialisiert, d. h. die Registerzelle ist bei 0, so daß die erste Leistungsanalyse unmittelbar das Hamming-Gewicht der ersten Zahl liefert. Je nach Anwendungsfall wird das Hamming-Gewicht einer geheimen Zahl dem Angreifer mehr oder weniger nützen. Dennoch ist es insbesondere für hochsichere Anwendungen, wie z. B. für SmartCards für Geldkarten, Personalidentitätskarten, etc. unerwünscht, daß überhaupt irgendwelche Informationen über geheime Zahlen, wie z. B. das Hamming-Gewicht der geheimen Zahl, nach außen dringen, da somit Sicherheitsrisiken entstehen können, die vielleicht heutzutage noch gar nicht absehbar sind.

Nachteilig an der bekannten Speicherzelle, wie sie in Fig. 2 dargestellt ist, ist ferner die Tatsache, daß, wie es ausgeführt worden ist und anhand von Fig. 3 erklärt worden ist, bei einer Datenänderung in der Registerzelle, also wenn der alte Wert im Register durch einen neuen überschrieben wird, ein Leistungsverbrauch auftritt, da beide Inverter von Fig. 2 ihren Zustand ändern, während, wenn keine Datenänderung in der Registerzelle auftritt, also wenn derselbe Wert als neuer Wert in die Registerzelle "geschrieben" wird, kein Leistungsverbrauch bzw. ein wesentlich geringerer Leistungsverbrauch auftritt. Ein Angreifer kann somit erkennen, ob eine Datenänderung in der Registerzelle stattgefunden hat oder nicht. Damit ergibt sich für die Registerzelle ein Sicherheitsleck, das insbesondere dann nachteilhaft ist, wenn die Registerzelle zum Speichern von sensitiven Daten, wie z. B. eines Bits eines geheimen Schlüssels, vorgesehen ist.

US-A-5 966 320 offenbart die Merkmale des Obergriffs des Anspruchs 1.

Die Aufgabe der vorliegenden Erfindung besteht darin, eine sicherere Registerzelle oder ein sichereres Verfahren zum Schreiben auf die Registerzelle zu schaffen.

Diese Aufgabe wird durch eine Registerzelle nach Anspruch 1 oder durch ein Verfahren zum Schreiben auf eine Registerzelle nach Anspruch 10 gelöst.

Der vorliegenden Erfindung liegt die Erkenntnis zugrunde, daß der Leistungsverbrauch der Registerzelle homogenisiert werden muß, d. h. daß unabhängig davon, ob der Zustand der Registerzelle geändert wird oder nicht, derselbe Leistungsverbrauch auftritt. Dies wird erfindungsgemäß dadurch erreicht, daß die Anzahl der Speicherschaltungen, die beispielsweise aus Invertern aufgebaut sind, einer Registerzelle verdoppelt wird, derart, daß eine erfindungsgemäße Registerzelle zwei Speicherschaltungen, wie z. B. zwei Paare von gegensinnig gekoppelten Invertern, aufweist, wobei der Eingang der Registerzelle für eine Dateneinheit mit der ersten Speicherschaltung, z. B. mit dem ersten Paar der gegensinnig gekoppelten Inverter, koppelbar ist, während der Eingang für die negierten Daten der Registerzelle mit der zweiten Speicherschaltung, z. B. dem zweiten Paar von gegensinnig gekoppelten Invertern, koppelbar ist.

Die Kopplung der beiden Eingänge mit der Leitung für die Dateneinheit und der Leitung für die negierte Dateneinheit findet mittels zweier steuerbarer Schalter statt, die geschlossen werden, wenn aus der Registerzelle gelesen wird oder in die Registerzelle geschrieben wird, und die offen sind, wenn die Registerzelle weder einer Lesen-Aktion noch einer Schreiben-Aktion unterworfen ist, sondern lediglich den gespeicherten Wert halten soll.

Der erfindungsgemäße Aufbau ermöglicht es, sowohl die Leitung für die Dateneinheit als auch die Leitung für die negierte Dateneinheit auf denselben logischen Zustand zu initialisieren, wobei diese Initialisierung entweder in einem Precharge oder in einem Discharge bestehen kann. Wenn eine Precharge-Initialisierung verwendet wird, so werden beide Datenleitungen auf einen hohen Spannungszustand initialisiert, während, wenn eine Discharge-Initialisierung verwendet wird, beide Leitungen auf einen niedrigen Spannungszustand initialisiert werden. Nachdem jeder "Nutzzustand" der Registerzelle darin besteht, daß der Eingang für die Daten einen Zustand hat und der Eingang für die negierten Daten einen zu dem einen Zustand inversen Zustand hat, muß - unabhängig davon, ob eine "1" oder "0" in die Registerzelle geschrieben wird - immer ein Inverterpaar seinen Zustand ändern, so daß der Leistungsverbrauch der Registerzelle für eine Precharge-Aktion, eine Discharge-Aktion oder eine Schreib-Aktion immer gleich ist. Ein Angreifer kann daher nicht erkennen, ob sich der Zustand der Registerzelle insgesamt betrachtet von einem Schreibvorgang zum nächsten geändert hat oder nicht.

Bevorzugte Ausführungsbeispiele der vorliegenden Erfindung werden nachfolgend Bezug nehmend auf die beiliegenden Zeichnungen detailliert erläutert. Es zeigen:
- Fig. 1a: ein Blockschaltbild einer erfindungsgemäßen Registerzelle;
- Fig. 1b: eine Sequenz von Schreib-Aktionen mit dazwischen liegenden Precharge-Aktionen;
- Fig. 1c: eine Sequenz von Schreib-Aktionen mit dazwischen liegenden Discharge-Aktionen;
- Fig. 2: ein Prinzipblockschaltbild einer Latch-Speicherzelle; und
- Fig. 3: ein Zeitdiagramm eines beispielhaften Datenflusses, der in die Latch-Speicherzelle von Fig. 2 geschrieben wird.

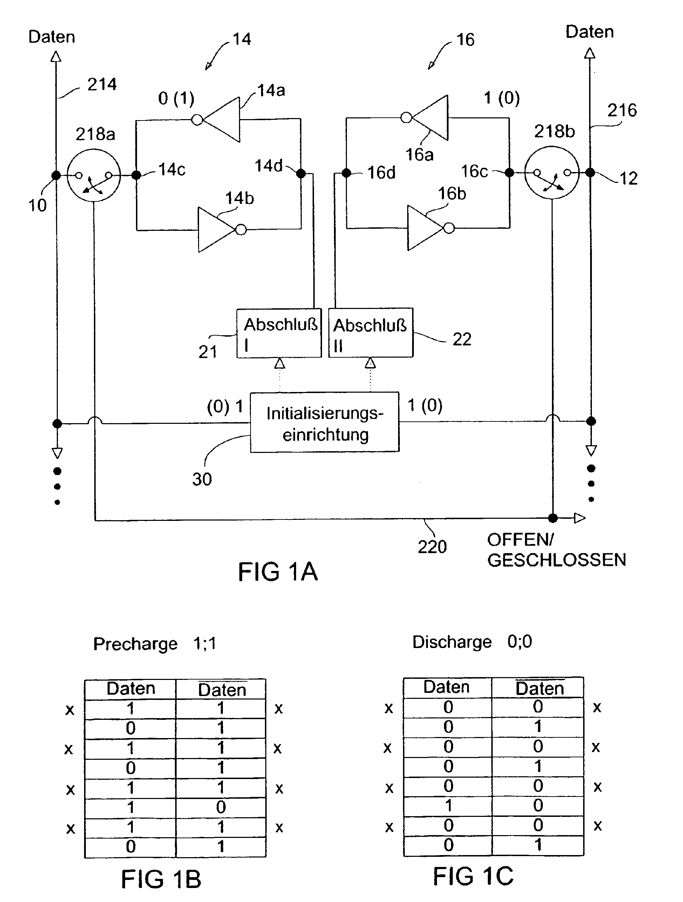

Fig. 1 zeigt ein Blockschaltbild einer erfindungsgemäßen sicheren Registerzelle. Die Registerzelle von Fig. 1a umfaßt ebenfalls wie in Fig. 2 für die bekannte Registerzelle beschrieben eine Leitung 214 für Daten sowie eine Leitung 216 für negierte Daten. Der Kopplungspunkt der Registerzelle mit der Leitung 214 für die Daten ist in Fig. 1a mit 10 bezeichnet. Er stellt den ersten Eingang der Registerzelle für eine von der Leitung 214 erhaltene auf die Registerzelle zu schreibende Dateneinheit dar. Ein Bezugszeichen 12 bezeichnet den zweiten Eingang der Registerzelle für eine in die Registerzelle zu schreibende negierte Dateneinheit. Mit dem ersten Eingang 10 ist über den einen steuerbaren Schalter 218a, der ebenso wie in Fig. 2 beschrieben ausgeführt sein kann, ein erstes Paar 14 gekoppelter Inverter koppelbar, während mit dem zweiten Eingang 12 über einen steuerbaren Schaltung 218b ein zweites Paar 16 von gegensinnig gekoppelten Invertern koppelbar ist. Das erste Paar 14 umfaßt einen ersten Inverter 14a sowie einen zweiten Inverter 14b, die gegensinnig gekoppelt sind, was in anderen Worten ausgedrückt bedeutet, daß ein Ausgang des ersten Inverters 14a an einem Verknüpfungspunkt 14c mit einem Eingang des zweiten Inverters 14b verbunden ist, während der Ausgang des zweiten Inverters 14b an einem weiteren Verknüpfungspunkt 14d mit einem Eingang des ersten Inverters 14a verbunden ist. Analog hierzu sind die beiden gegensinnig gekoppelten Inverter 16a, 16b des zweiten Paars 16 miteinander verbunden, derart, daß ein erster Verbindungspunkt 16c mit dem zweiten Eingang 12 koppelbar ist, während ein zweiter Verbindungspunkt 16d einen Ausgang des ersten Inverters 16a mit dem Eingang 16 des zweiten Inverters 16b verbindet.

Mit dem zweiten Verbindungspunkt 14d des ersten Paars 14 ist eine erste Abschlußeinrichtung 21 verbunden, während in Analogie hierzu mit dem zweiten Verbindungspunkt 16d des zweiten Paars 16 von gegensinnig gekoppelten Invertern eine zweite Abschlußeinrichtung 22 verbunden ist. Um eine Initialisierung sowohl der Datenleitung 214 als auch der Leitung 216 für negierte Daten zu erreichen, ist ferner eine Initialisierungseinrichtung 30 vorgesehen, die entweder nur auf die Leitungen 214 und 216 einwirkt, oder die auf die erste Abschlußeinrichtung 21 und auf die zweite Abschlußeinrichtung 22 einwirkt, wie es durch gestrichelte Verbindungspfeile in Fig. 1a gezeigt ist, oder die sowohl auf die Leitungen 214, 216 als auch auf die Abschlußeinrichtung 21, 22 einwirkt, um entweder eine Precharge-Aktion mit der Registerzelle oder eine Discharge-Aktion mit der Registerzelle durchzuführen.

Nachfolgend wird die Funktionsweise der in Fig. 1a gezeigten Speicherzelle beschrieben. Die Speicherzelle kann zwei Zustände haben. Sie kann entweder eine logische "0" speichern. In diesem Fall liegt an dem ersten Verbindungspunkt 14c des ersten Paars 14 von gegensinnig gekoppelten Invertern 14a, 14b ein Spannungszustand an, der die logische "0" verkörpert. Dies bedeutet automatisch, daß an dem ersten Verbindungspunkt 16c des zweiten Paars 16 von gegensinnig gekoppelten Invertern 16a, 16b eine logische "1" anliegt, d. h. ein Spannungszustand, der die logische "1" verkörpert. Die andere Möglichkeit besteht darin, daß an dem Verbindungspunkt 14c eine logische "1" anliegt, während an dem ersten Verbindungspunkt 16c des zweiten Paars 16 eine logische "0" anliegt, wie es in Fig. 1a durch die Option in Klammern dargestellt ist. Soll von der in Fig. 1a gezeigten Speicherzelle gelesen werden, so werden die Schalter 218a, 218b über die Steuerleitung 220 geöffnet, und das erste Paar 14 treibt die Leitung 214 für die Daten, während das zweite Paar 16 die Leitung 216 für die negierten Daten treibt, um den Registerzustand zu einem Empfänger für den Registerzustand zu übermitteln.

Soll dagegen auf die erfindungsgemäße Registerzelle geschrieben werden, so wird die Initialisierungseinrichtung 30 dahingehend aktiv, daß sowohl das erste Paar 14 der gegensinnig gekoppelten Inverter als auch das zweite Paar 16 der gegensinnig gekoppelten Inverter auf denselben logischen Zustand initialisiert werden, dahingehend, daß an den Verbindungspunkten 14c, 16c entweder ein hoher Spannungszustand anlegt (Precharge-Aktion) oder ein niedriger Spannungszustand anlegt (Discharge-Aktion).

An dieser Stelle sei darauf hingewiesen, daß die Möglichkeit einer Initialisierung der beiden Verbindungspunkte 212a, 212b von Fig. 2 auf denselben Spannungspegel bzw. auf denselben logischen Zustand nicht gegeben ist, da dies ja gerade das Wesen der beiden Inverter 200, 210 ist, an ihrem Ausgang bzw. Eingang den entgegengesetzten logischen Zustand zu erzeugen als an ihrem Eingang bzw. Ausgang.

Fig. 1b zeigt eine Tabelle über eine zeitliche Sequenz von Schreibvorgängen, jedoch nunmehr mit dazwischen liegenden Precharge-Takten, die in Fig. 1b mit Kreuzen gekennzeichnet sind. Die Datensequenz ist dieselbe, wie sie in Fig. 3 dargestellt ist.

Fig. 1c zeigt den analogen Fall, jedoch nunmehr mit dazwischen liegenden Discharge-Vorgängen, die ebenfalls wieder mit Kreuzen gekennzeichnet sind. Bei der Betrachtung der Fig. 1b und 1c wird ersichtlich, daß sich von einem Arbeitstakt zum nächsten immer nur entweder der Zustand der Daten oder der Zustand der negierten Daten ändert. Es ändert sich niemals sowohl der Zustand der Daten als auch der negierten Daten, oder es bleibt niemals der Zustand der Daten oder der Zustand der negierten Daten gleich. Auf die in Fig. 1a gezeigte Schaltung bezogen bedeutet dies, daß sich von einem Arbeitstakt zu nächsten immer entweder der Zustand des ersten Paars 14 oder der Zustand des zweiten Paars 16 ändert, daß sich jedoch niemals sowohl der Zustand des ersten Paars 14 als auch der Zustand des zweiten Paars 16 ändert, oder daß niemals der Zustand des ersten Paars 14 und der Zustand des zweiten Paars 16 unverändert bleiben.

Es sei darauf hingewiesen, daß die in Fig. 1b und Fig. 1c gezeigten Lese-Sequenzen lediglich beispielhafte Lese-Sequenzen sind. So wird bereits ein Sicherheitsvorteil erreicht, wenn nicht vor jedem Schreiben auf das Register eine Initialisierung durchgeführt wird, sondern wenn beispielsweise nur vor jedem zweiten, dritten, ...., n-ten Lesevorgang eine Registerinitialisierung mit Precharge oder Discharge vorgenommen wird. Es sei ferner darauf hingewiesen, daß, sofern eine entsprechende Vereinbarung getroffen ist, die Intervalle, in denen eine Initialisierung des Registers vorgenommen wird, auch unregelmäßig sein können. Es sei ferner darauf hingewiesen, daß Precharge und Discharge auch abgewechselt werden können. Auch in diesem Fall wird sich von einem Arbeitstakt zum nächsten immer nur der Zustand eines Paars von gegensinnig gekoppelten Invertern von Fig. la ändern, es werden sich jedoch nie die Zustände beider Paare ändern, oder es werden nie die Zustände beider Paare gleich bleiben. Man sieht somit nicht, ob sich die Daten ändern oder nicht, was in einem Sicherheitsvorteil resultiert.

Es sei darauf hingewiesen, daß die in Fig. la gezeigte Registerzelle doppelt so viele Transistoren benötigt, wie eine einfache in Fig. 2 gezeigte Registerzelle. Die Anzahl der Steuerschalter 218a, 218b ist jedoch in beiden Fällen gleich. Die Verdopplung der Anzahl von Transistoren ist insbesondere bei Langzahlregistern, die beispielsweise Längen von über 2048 Bit für bestimmte kryptographische Anwendungen haben können, sehr chipflächenintensiv. Daher wird es bevorzugt, die in Fig. la gezeigte Registerzelle nur zum Aufbau von Hochsicherheitsregistern zu verwenden, in denen tatsächlich sensitive Daten gespeichert sind, während weniger sensitive Daten in einfachen Registern mit Registerzellen der in Fig. 2 gezeigten Ausführung untergebracht werden. Insbesondere in Anwendungen für die sichere Registerzelle beispielsweise auf einer SmartCard, auf der eine Vielzahl von Rechnungen durchgeführt wird und eine Vielzahl von in Registern zu speichernden Zwischenergebnissen anfallen, sind nur wenige Daten derart sensitiv, daß sie in dem aufwendigen Hochsicherheitsregister mit Registerzellen der in Fig. la gezeigten Ausführung zu speichern sind. Wenn daher konsequent darauf geachtet wird, lediglich die sensitiven Daten in aufwendigen Sicherheitsregistern unterzubringen, und für die restlichen Daten einfache Register zu nehmen, so wird der Chipflächenbedarf insgesamt gesehen lediglich gering ansteigen, während der Gewinn an zusätzlicher Sicherheit durch besonderen Schutz der besonders empfindlichen Daten beträchtlich ist.

Bezugszeichenliste
10 erster Eingang der Registerzelle
12 zweiter Eingang der Registerzelle
14 erstes Paar
14a erster Inverter
14b zweiter Inverter
14c erster Verbindungspunkt
14d zweiter Verbindungspunkt
16 zweites Paar
16a erster Inverter
16b zweiter Inverter
16c erster Verbindungspunkt
16d zweiter Verbindungspunkt
21 erste Abschlußeinheit
22 zweite Abschlußeinheit
30 Initialisierungseinrichtung
200 erster Inverter
210 zweiter Inverter
212a erster Kopplungspunkt
212b zweiter Kopplungspunkt
214 Leitung für die Daten
216 Leitung für die negierten Daten
218a erster gesteuerter Schalter
218b zweiter gesteuerter Schalter
220 Steuerleitung für die gesteuerten Schalter

## Patentansprüche

1. Registerzelle mit folgenden Merkmalen:
einem ersten Eingang (10) für eine in die Registerzelle zu schreibende Dateneinheit;
einem zweiten Eingang (12) für eine in die Registerzelle zu schreibende negierte Dateneinheit;
einer ersten Speicherschaltung (14), die mit dem ersten Eingang (10) koppelbar ist; und
einer zweiten Speicherschaltung (16), die mit dem zweiten Eingang (12) koppelbar ist;
**gekennzeichnet durch**
eine Initialisierungseinrichtung (30), die ausgebildet ist, um die Registerzelle so anzusteuern, dass die erste Speicherschaltung (14) und die zweite Speicherschaltung (16) auf den selben logischen Zustand initialisiert werden.

2. Registerzelle nach Anspruch 1, bei der die erste Speicherschaltung ein erstes Paar (14) von gegensinnig gekoppelten Invertern (14a, 14b) aufweist.

3. Registerzelle nach Anspruch 1 oder 2, bei der die zweite Speicherschaltung ein zweites Paar (16) von gegensinnig gekoppelten Invertern (16a, 16b) aufweist.

4. Registerzelle nach Anspruch 3,
bei der das erste Paar von gegensinnig gekoppelten Invertern über einen ersten Steuerschalter (218a) mit dem Eingang (10) koppelbar ist; und
bei dem das zweite Paar von gegensinnig gekoppelten Invertern über einen zweiten Steuerschalter (218a) mit dem zweiten Eingang (12) koppelbar ist.

5. Registerzelle nach Anspruch 3 oder 4,
bei der die Inverter (14a, 14b) des ersten Paars (14) und die Inverter (16a, 16b) des zweiten Paars (16) so gekoppelt sind, daß ein Eingang jedes Inverters des Paars mit einem Ausgang des anderen Inverters des Paars verbunden ist.

6. Registerzelle nach einem der Ansprüche 3 bis 5,
bei der das erste Paar (14) und das zweite Paar (16) keine Spannungskopplung zueinander haben.

7. Registerzelle nach einem der Ansprüche 3 bis 6,
bei der ein Verbindungspunkt (14c, 16c) der Inverter eines Paars (14, 16) mit dem zugeordneten Eingang (10, 12) koppelbar ist und ein zweiter Verbindungspunkt (14d, 16d) der Inverter mit einer Abschlußeinheit (21, 22) gekoppelt ist, welche ausgebildet ist, um an dem zweiten Verbindungspunkt (14d, 16d) einen logischen Zustand zu ermöglichen, der invers zu dem logischen Zustand an dem entsprechenden ersten Verbindungspunkt (14c, 16c) ist.

8. Registerzelle nach Anspruch 1,
bei der die Initialisierungseinrichtung (30) eine Precharge-Einrichtung aufweist und der logische Zustand des ersten Eingangs (10) und des zweiten Eingangs (12) durch einen hohen Spannungszustand dargestellt ist.

9. Registerzelle nach Anspruch 1,
bei der die Initialisierungseinrichtung (30) eine Discharge-Einrichtung aufweist und der logische Zustand des ersten Eingangs (10) und des zweiten Eingangs (12) durch einen niedrigen Spannungszustand dargestellt ist.

10. Verfahren zum Schreiben auf eine Registerzelle mit einem ersten Eingang (10) für eine in die Registerzelle zu schreibende Dateneinheit, einem zweiten Eingang (12) für eine in die Registerzelle zu schreibende negierte Dateneinheit, einer ersten Speicherschaltung (14), die mit dem ersten Eingang koppelbar ist, und einer zweiten Speicherschaltung (16), die mit dem zweiten Eingang koppelbar ist, mit folgenden Schritten:
Initialisieren der ersten Speicherschaltung (14) und der zweiten Speicherschaltung (16) auf denselben Zustand;
Schreiben der Dateneinheit über den ersten Eingang (10) auf die erste Speicherschaltung (14); und
Schreiben der negierten Dateneinheit über den zweiten Eingang (12) auf die zweite Speicherschaltung (16).

11. Verfahren nach Anspruch 10,
bei dem der Zustand ein hoher Spannungszustand ist.

12. Verfahren nach Anspruch 10,
bei dem der Zustand ein niedriger Spannungszustand ist.

## Claims

1. Register cell, comprising:
a first input (10) for a data unit to be written into the register cell;
a second input (12) for a negated data unit to be written into the register cell;
a first storage circuit (14) which is adapted to be coupled to the first input (10); and
a second storage circuit (16) which is adapted to be coupled to the second input (12);
**characterized by**
an initialization means (30) configured to control the register cell such that the first storage circuit (14) and the second storage circuit (16) are initialized to the same logic state.

2. Register cell in accordance with claim 1, wherein the first storage circuit comprises a first pair (14) of oppositely coupled inverters (14a, 14b).

3. Register cell in accordance with claim 1 or 2, wherein the second storage circuit comprises a second pair (16) of oppositely coupled inverters (16a, 16b).

4. Register cell in accordance with claim 3,
wherein the first pair of oppositely coupled inverters is adapted to be coupled to the input (10) via a first control switch (218a); and
wherein the second pair of oppositely coupled inverters is adapted to be coupled to the second input (12) via a second control switch (218a).

5. Register cell in accordance with claim 3 or 4,
wherein the inverters (14a, 14b) of the first pair (14) and the inverters (16a, 16b) of the second pair (16) are coupled such that an input of each inverter of the pair is coupled to an output of the other inverter of the pair.

6. Register cell in accordance with one of claims 3 to 5,
wherein the first pair (14) and the second pair (16) do not have any voltage coupling to each other.

7. Register cell in accordance with one of claims 3 to 6,
wherein a connection point (14c, 16c) of the inverters of a pair (14, 16) is adapted to be coupled to the associated input (10, 12) and a second connection point of the inverters is coupled to a terminating unit (21, 22), which is implemented to enable a logic state at the second connection point (14d, 16d) which is inverse to the logic state at the corresponding first connection point (14c, 16c).

8. Register cell in accordance with claim 1,
wherein the initialization means (30) comprises a precharge means and the logic state of the first input (10) and of the second input (12) is represented by a high voltage state.

9. Register cell in accordance with claim 1,
wherein the initialization means (30) comprises a discharge means and the logic state of the first input (10) and of the second input (12) is represented by a low voltage state.

10. Method for writing to a register cell with a first input (10) for a data unit to be written into the register cell, a second input (12) for a negated data unit to be written into the register cell, a first storage circuit (14), which is adapted to be coupled to the first input, and a second storage circuit (16), which is adapted to be coupled to the second input, comprising the following steps:
initializing the first storage circuit (14) and the second storage circuit (16) to the same state;
writing the data unit via the first input (10) to the first storage circuit (14); and
writing the negated data unit via the second input (12) to the second storage circuit (16).

11. Method in accordance with claim 10,
wherein the state is a high voltage state.

12. Method in accordance with claim 10,
wherein the state is a low voltage state.

## Revendications

1. Cellule de registre, aux caractéristiques suivantes :
une première entrée (10) pour une unité de données à écrire dans la cellule de registre ;
une deuxième entrée (12) pour une unité de données niée à écrire dans la cellule de registre ;
un premier circuit de mémoire (14) qui peut être couplé à la première entrée (10) ; et
un deuxième circuit de mémoire (16) qui peut être couplé à la deuxième entrée (12) ;
**caractérisée par**
un dispositif d'initialisation (30) qui est réalisé de manière à activer la cellule de registre de sorte que le premier circuit de mémoire (14) et le deuxième circuit de mémoire (16) soient initialisés au même état logique.

2. Cellule de registre selon la revendication 1, dans laquelle le premier circuit de mémoire présente une première paire (14) d'inverseurs couplés en sens opposé (14a, 14b).

3. Cellule de registre selon la revendication 1 ou 2, dans laquelle le deuxième circuit de mémoire présente une deuxième paire (16) d'inverseurs couplés en sens opposé (16a, 16b).

4. Cellule de registre selon la revendication 3,
dans laquelle la première paire d'inverseurs couplés en sens opposé peut être couplée, par l'intermédiaire d'un premier commutateur de commande (218a), à l'entrée (10) ; et
dans laquelle la deuxième paire d'inverseurs couplés en sens opposé peut être couplée, par l'intermédiaire d'un deuxième commutateur de commande (218a), à la deuxième entrée (12).

5. Cellule de registre selon la revendication 3 ou 4,
dans laquelle les inverseurs (14a, 14b) de la première paire (14) et les inverseurs (16a, 16b) de la deuxième paire (16) sont couplés de sorte qu'une entrée de chaque inverseur de la paire soit reliée à une sortie de l'autre inverseur de la paire.

6. Cellule de registre selon l'une des revendications 3 à 5,
dans laquelle la première paire (14) et la deuxième paire (16) n'ont pas de couplage de tension entre elles.

7. Cellule de registre selon l'une des revendications 3 à 6,
dans laquelle un point de connexion (14c, 16c) des inverseurs d'une paire (14, 16) peut être couplé à l'entrée associée (10, 12) et un deuxième point de connexion (14d, 16d) des inverseurs est couplé à une unité de terminaison (21, 22) qui est réalisée de manière à permettre, au deuxième point de connexion (14d, 16d), un état logique qui est inverse à l'état logique au premier de connexion correspondant (14c, 16c).

8. Cellule de registre selon la revendication 1,
dans laquelle le dispositif d'initialisation (30) présente un dispositif de précharge et l'état logique de la première entrée (10) et de la deuxième entrée (12) est représenté par un état de haute tension.

9. Cellule de registre selon la revendication 1,
dans laquelle le dispositif d'initialisation (30) présente un dispositif de décharge et l'état logique de la première entrée (10) et de la deuxième entrée (12) est représenté par un état de basse tension.

10. Procédé pour effectuer une inscription dans une cellule de registre avec une première entrée (10) pour une unité de données à écrire dans la cellule de registre, une deuxième entrée (12) pour une unité de données niée à écrire dans la cellule de registre, un premier circuit de mémoire (14) qui peut être couplé à la première entrée, et un deuxième circuit de mémoire (16) qui peut être couplée à la deuxième entrée, aux étapes suivantes consistant à :
initialiser le premier circuit de mémoire (14) et le deuxième circuit de mémoire (16) au même état ;
écrire l'unité de données, par l'intermédiaire de la première entrée (10), sur le premier circuit de mémoire (14) ; et
écrire l'unité de données niée, par l'intermédiaire de la deuxième entrée (12), sur le deuxième circuit de mémoire (16).

11. Procédé selon la revendication 10,
dans lequel l'état est un état de haute tension.

12. Procédé selon la revendication 10,
dans lequel l'état est un état de basse tension.
